# EUROPEAN PATENT SPECIFICATION

(11) **EP 3 058 596 B1**
(45) Date of publication and mention of the grant of the patent: **27.12.2017**
(21) Application number: 14790782.8
(22) Date of filing: 17.10.2014
(51) Int. Cl.: H01L 31/042, H01L 31/05

(54) **ASSEMBLY OF PHOTOVOLTAIC CELLS AND FABRICATION THEREOF**
ANORDNUNG VON PHOTOVOLTAIKZELLEN UND HERSTELLUNGSVERFAHREN DAFÜR
ENSEMBLE DE CELLULES PHOTOVOLTAÏQUES ET SON PROCÉDÉ DE FABRICATION

(30) Priority: 18.10.2013 NL 2011647
(43) Date of publication of application: 24.08.2016
(73) Proprietor: Stichting Energieonderzoek Centrum Nederland, 1755 LE Petten (NL)
(72) Inventor: JANSEN, Markus Johan, 1755 LE Petten (NL); VAN ROOSMALEN, Johannes Adrianus Maria, 1755 LE Petten (NL); BENDE, Evert Eugène, 1755 LE Petten (NL); CARR, Anna Judith, 1755 LE Petten (NL); GUILLEVIN, Nicolas, 1755 LE Petten (NL); HEURTAULT, Benoit Jean Baptiste, 1755 LE Petten (NL)
(74) Representative: V.O.
(86) International application number: PCT/NL2014/050724
(87) International publication number: WO 2015/057071

(56) References cited:
- WO-A1-2010/037393
- US-A1- 2012 060 895

## Description

### Field of the invention

The invention relates to an assembly of photovoltaic cells.

### Background

US20120060895 discloses an assembly of photovoltaic cells comprising a matrix of photovoltaic cells that are connected in series to produce a sum of the output voltages of the individual cells at the terminals of the assembly. An assembly of photovoltaic cells may be a solar energy collection module, further comprising a package and electrical connections. The series connection follows an alternating back and forth pattern through the matrix to facilitate connection of bypass diodes. In the back and forth pattern the series connection each time runs along a row perpendicularly inward from an edge of the matrix up to halfway along the row (through three cells), then to midway the next row and back to the edge through that next row, from there to the following row and inward again etc. At the last row of the matrix the series connection crosses over to the opposite edge and continues with similar back and forth patterns from that edge.

The bypass diodes are connected in parallel to groups of the cells. In US20120060895, such a group is formed by the series connected cells inward along a row in the back and forth pattern up to halfway along that row and back from cells halfway the next row. Bypass diodes are known per se in photovoltaic cell assemblies. They compensate for the effect that shadowed cells act as sources with a negative voltage, associated with dissipation of energy. The bypass diode clips the voltage drop over its group of cells, rerouting the current around the group. The back and forth pattern of US20120060895 exposes connections to the cells at the start and end of the group at the edge of the matrix, where it is easy to provide the bypass diode.

However in US20120060895 the space used for the bypass diodes along the edges, and for the connection between opposite edges, may reduce the area available for energy collection. This problem would increase when the number of bypass diodes would be increased. Although bypass diodes counteract energy loss due to shadowing of the assembly as a whole, energy produced by any cell in a group will be lost when shadowing of part of the cells in the group causes forward bias of the bypass diode. Thus awkward shadows, which hit a few cells in many groups, say along the edge of the matrix, can still result in a disproportional reduction of energy production. This loss can be reduced by decreasing cell area in each group, i.e. by increasing the number of bypass diodes for a given area. But in the cell of US20120060895 this would reduce the area available for energy collection.

Preferably, a solar cell assembly is combined with a DC to AC conversion circuit configured to produce an AC line voltage (e.g. 220 Volt AC). Such a conversion circuit typically comprises a DC-DC converter followed by a DC-AC converter. The DC-DC converter compensates output voltage fluctuations, e.g. due to shadowing, line voltage fluctuations etc. The efficiency of the DC-DC converter can be optimized when the nominal DC voltage is substantially equal to the peak line voltage. Conversion circuits wherein the DC-AC converter performs compensation are also known. These are similarly more efficient for such DC voltages.

WO2010037393A1 discloses a solar cell assembly wherein DC-DC converters are used to increase the output voltage of the assembly. The solar cells are divided into sub-cells that are coupled in series. A DC-DC converter is connected to the series connection of a number of the sub-cells. A DC-DC converters serve to raise the DC output voltage of the assembly, to a level above standard line voltage (e.g. 220 Volt AC), to facilitate conversion to AC at that line voltage. Without DC-DC converters more than 500 sub-cells would be needed to realize the 310 Volts DC needed to realize such an AC voltage with optimal DC-DC conversion in the case of Si based solar sub-cells, which each produce about 0.5 Volt. The use of DC-DC converters for use with strongly different DC voltages raises cost and reduces average operational life-time of the assembly. Such use of high voltages well above 0.5 Volts may make it necessary to increase the distance between cells to provide sufficient electrical isolation. But increased distances lead to reduced light collection area and hence to less output power per unit area of solar modules.

### Summary

Among others, it is an object to provide for an assembly of photovoltaic cells, such as a solar energy collection module, wherein a high fraction of the area of the assembly is used for energy collection. An assembly of photovoltaic cells is provided that comprises a matrix of photovoltaic cells, an electrical connection structure providing a series connection of the cells, and bypass diodes connected in parallel with respective parts of the series connection. Preferably all back contract photovoltaic cells are used, i.e. cells with a back surface that contains contacts to base and emitter areas of the cell respectively. The electrical connection structure comprises rows of first sub-matrix connection patterns. Each of the first sub-matrix connection patterns provides the series connection within a sub-matrix of rows and columns of photovoltaic cells. Each first sub-matrix connection pattern provides one of the respective parts of the series connection, extending over a plurality of rows of photovoltaic cells of the matrix, running back and forth along successive columns through the plurality of rows. The first sub-matrix connection patterns at ends of a pair of the rows of first sub-matrix connection patterns are indirectly connected to each other. Rather than using a conductor to connect these first sub-matrix connection patterns, the connection is provided through second sub-matrix connection patterns that provide further ones of the respective parts of the series connection. Each of the second sub-matrix connection patterns provides the series connection within a sub-matrix of rows and columns of photovoltaic cells. These second sub-matrix connection patterns extend over a plurality of columns of the matrix. This makes it possible to realize the connection between the rows of first sub-matrix connection patterns using assembly surface area that is used for photovoltaic cells.

Each of the first and second sub-matrix connection patterns provides the series connection within a sub-matrix with rows and columns of photovoltaic cells. Preferably the sub-matrix is rectangular or rectangular with beveled corners and more preferably square. The photovoltaic cell at a first corner of the rectangular sub-matrix is at an end of the part of the series connection in the first or second sub-matrix connection pattern. These first corners of the first and second sub-matrix connection patterns at the end of the row lie adjacent to one another. The first and second sub-matrix connection patterns are electrically connected to each other at these first corners. In an embodiment, in the first sub-matrix connection pattern at the end of each row of the pair, the first corner lies away from the other row of the pair, that is, there is at least one row of photovoltaic cells in the sub-matrix intermediate between the photovoltaic cell at the first corner and the other row of first sub-matrix connection patterns. This results in a distance corresponding to a plurality of intermediate photovoltaic cells between the cells at the first corners, which is bridged via the photovoltaic cells that are connected by the second sub-matrix connection patterns. In an embodiment the photovoltaic cells at the first corner and a second corner of the rectangular sub-matrix are at opposite ends of the part of the series connection in the sub-matrix connection pattern. These first and second corners are adjacent corners (i.e. not diagonally opposite). In the first sub-matrix connection patterns they lie in a same row of the matrix and in the second sub-matrix connection patterns the lie in a same column. The first sub-matrix connection patterns in the rows are electrically connected to each other at these first and second corners. The second sub-matrix connection patterns are electrically connected to each other at these second corners. Preferably, the rows of first sub-matrix connection in each pair are mirror images of each other. More preferably, the electrical connection structure comprises successive rows of connections that are alternately mirror images of each other.

In an embodiment the second corners of the first sub-matrix connection patterns at further ends of the rows in the pair, opposite the ends where the second sub-matrix connection patterns are located, are connected directly to adjacent first sub-matrix connection patterns in further rows of first sub-matrix connection patterns that are adjacent to rows in the pair.
In an embodiment, the first sub-matrix connection patterns at the ends of the pair of the rows each run back and forth through P rows, and the second sub-matrix connection patterns each run P times back and forth through the plurality of columns (that is, the number of time that the pattern runs forth plus the number of times that the pattern runs back equals P). In this way, the second sub-matrix connection patterns fit along the edge of the first sub-matrix connection pattern. If the shape of the photovoltaic cells deviates substantially from a square shapes, the photovoltaic cells connected by the second sub-matrix connection patterns may need to be arranged rotated by ninety degrees relative to those connected by the first sub-matrix connection patterns.

In an embodiment, the first sub-matrix connection patterns at the ends of the pair of the rows each run a second number Q times back and forth through said first number P of rows, and the second first sub-matrix connection patterns each run said first number P times back and forth through said second number Q of columns. Thus, the number of cells in each sub-matrix connection pattern is the same, which optimizes use of the bypass diodes.

In an embodiment P and Q are equal, i.e. sub-matrices of PxP cells are used. P may be four for example. Thus, substantially square sub-matrices are used, which makes the ratio between the maximum diameter of the sub-matrix and the number of cells in the sub-matrix small. This in turn reduces the number of sub-matrices that will generally be affected by the shadow of a given size.

In an embodiment, the bypass diodes are located at edges of the first and second sub-matrix connection patterns. This makes it possible to minimize the length of the conductors to the bypass diodes and hence resistive loss in the case of shadows.

In an embodiment, all photovoltaic cells in the matrix have identical orientation (i.e. the direction between corresponding contact points is the same). This simplifies placement of the cells. In this embodiment the first sub-matrix connection pattern having identical layouts, the second sub-matrix connection pattern having layouts that differ from that of the first sub-matrix connection pattern. Thus, the layout compensates for the fact that the connections need to be different for the multi-column second sub-matrix connection patterns when the cells have the same orientation.

In an embodiment each of the first and second sub-matrix connection patterns comprises a first and second one of the photovoltaic cells at the ends of the respective part of the series connection that is provided by the sub-matrix connection pattern, the first and second one of the photovoltaic cells being located along a straight edge of the sub-matrix connection pattern, the electrical connection structure in the sub-matrix connection pattern comprising a pair of areas of electrically conducting material extending along said edge, electrically connected to contacts of the first and second one of the photovoltaic cells respectively, the bypass diode that is connected in parallel with the photovoltaic cells of the respective part of the series connection being located at said edge, electrically connected between the pair of areas. This minimizes the length of the conductors to the bypass diodes and hence resistive loss in the case of shadows.

In an embodiment, each of the first and second sub-matrix connection patterns comprises a first and second one of the photovoltaic cells at the ends of the respective part of the series connection that is provided by the sub-matrix connection pattern, the electrical connection structure in the sub-matrix connection pattern comprising a first and second areas of electrically conducting material, electrically connected to contacts of the first and second one of the photovoltaic cells respectively, the bypass diode that is connected in parallel with the photovoltaic cells of the respective part of the series connection being located between a further contact of the first one of the photovoltaic cells and the second area of electrically conducting material. This makes simplifies manufacture by making positioning of the diodes less critical.

According to another aspect method of manufacturing an assembly of photovoltaic cells is provided, the method comprising
- providing an electrical connection structure that provides for a series connection of the photovoltaic cells,
- providing bypass diodes on said electrical connection structure, each bypass diode for connection in parallel with the photovoltaic cells of a respective part of the series connection;
- arranging the photovoltaic cells in a matrix with rows and columns of photovoltaic cells;
- establishing electrical contact between contacts of the photovoltaic cells and the electrical connection structure, wherein the electrical connection structure comprises
- rows of first sub-matrix connection patterns, each first sub-matrix connection pattern providing one of the respective parts of the series connection, extending over a plurality of rows of photovoltaic cells of the matrix, running back and forth along successive columns through the plurality of rows;
- second sub-matrix connection patterns, connecting the first sub-matrix connection patterns at ends of a pair of the rows of first sub-matrix connection patterns, each second sub-matrix connection pattern providing a further one of the respective parts of the series connection, extending over a plurality of columns of photovoltaic cells of the matrix, running back and forth along successive rows through the plurality of columns.
In an embodiment, photovoltaic cells cut from wafers in said step of arranging the photo-voltaic cells are used in the matrix with rows and columns of photovoltaic cells. By using cells that are smaller than wafers, it is made possible to used bypass diodes for groups of cells that occupy less area. Thus, shadowing will have less effect.

In an embodiment according to any one of the claims the number of cells in the matrix is at least 500, so that the nominal voltage output is at least 310 V DC for conversion to 220V AC. In an embodiment according to any one of the claims the assembly comprises a DC to DC down-converter, connected to the terminals of the series connection of the cells in the matrix. In an embodiment according to any one of the claims the assembly comprises a DC to AC down-converter, connected to the terminals of the series connection of the cells in the matrix.

In an embodiment according to any one of the claims the interconnection material that interconnects the cells in series is a conductive foil. Preferably a flat diode is used, i.e. a diode having opposite surface areas, wherein the distance between the surface areas is smaller than the minimum diameter of the surface areas, cathode and anode connections of the diode being located on opposite ones of the surface areas. Any type of diode may be used. In an embodiment the bypass diode is a piece of a cell of a same structure as the cells in the matrix, sandwiched in between the cell and the foil.

In an embodiment according to any one of the claims the terminals of the series connection of cells are located adjacent two opposite sides of the matrix.

### Brief description of the drawing

These and other objects and advantageous aspects will become apparent from a description of exemplary embodiments with reference to the following figures.
Figure 1 shows a matrix of photo-voltaic cells
Figure 2 shows a cross-section through an assembly of photovoltaic cells
Figure 3a shows a layout of a connection pattern in a sub-matrix
Figure 3b shows a schematic connection pattern in a sub-matrix
Figure 4 shows sub-matrices that divide a matrix
Figure 5a shows a schematic connection pattern in a sub-matrix
Figure 5b shows a layout of a connection pattern in a sub-matrix
Figure 6 shows connection of a bypass diode
Figure 7, 7a illustrate use of sub-matrix with non-rectangular cells

### Detailed description of exemplary embodiments

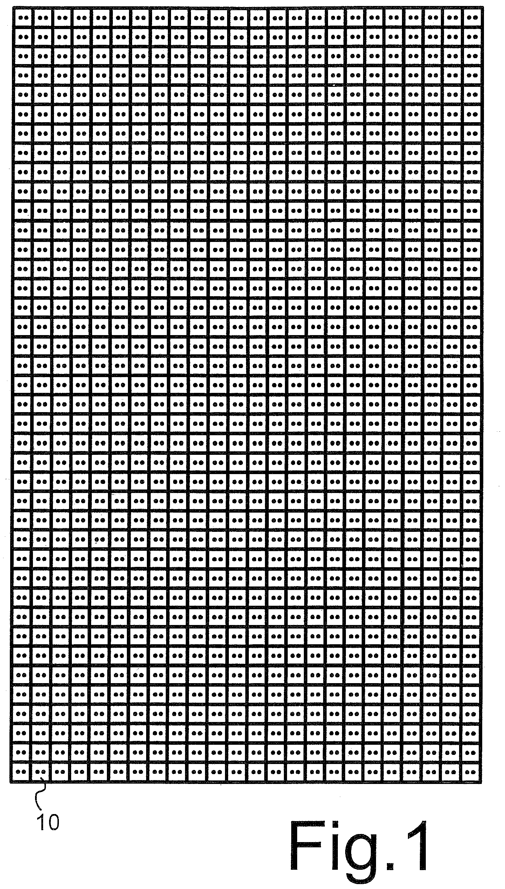

Figure 1 symbolically shows photovoltaic cells in a matrix with N rows and M columns of photovoltaic cells 10 (only one labeled). By way of example a matrix of N=24 and M=40 rows and columns is shown, giving a total of NxM=960 cells. The matrix is part of a photovoltaic energy collection module with electrical output terminals. Electrically, the cells are connected in series between terminals. Si based cells may be used, which produce a DC voltage output of about 0.5-0.6 Volts, so that a total output voltage of about 480 Volts between the terminals can be realized. In addition one or more DC-DC converters may be used to convert the DC voltage of the string to the desired output voltage. Preferably, the voltage is at least about 155 or 310 Volts for conversion to 220V AC and in an embodiment at least about 270 or 540 Volts, for three phase conversion. In this case no up-conversion is needed for DC to AC conversion at 220(110) Volt and 380(190) Volt respectively, which simplifies the electronic circuit design, saves cost and yields a higher efficiency. Preferably, different embodiments of the matrix have at least five hundred cells, two hundred fifty cells, nine hundred cells and four hundred fifty cells respectively. Some excess cells may be advantageous to allow for compensation of temperature effects, variation in line voltage, shading etc.

The matrix is part of a photovoltaic cell assembly, which may comprise a casing of the matrix with a window for exposing the cells to external light and electrodes coupled to the matrix. As may be noted electrical output terminals are located adjacent rows on opposite sides of the columns, the columns being longer than the rows. In this way, the distance between the terminals is maximized, which reduces high voltage protection requirements In an embodiment, a photovoltaic cell assembly comprises an electronic DC to DC down converter (not shown) coupled to the terminals.

For each photovoltaic cell, contacts on the cell for electrical connections to the cell have been indicated symbolically as a pair of dots. By way of example, the contacts within a cell may be offset relative to each other in the column direction. Preferably, the contacts are located near the centre of the surface of the cell, so as to minimize resistance between the contact and the edges of the surface. All photovoltaic cells in the matrix have the same orientation, in the sense that the offset direction between the contacts is the same within each cell in the matrix.

Preferably all back contact cells are used, i.e. cells with a back surface that contains contacts to base and emitter areas of the cell respectively. In an embodiment, the photovoltaic cells 10 may be metal wrap through cells, i.e. cells wherein a front surface electrode is connected to a first contact electrode on the back surface of the cell via a hole through the cell, and a second contact on the back surface connects to (or forms part of) a back surface electrode that covers the remainder of the back surface of the cell. Alternatively, other types of cell may be used, for example, cells that have interdigitated base and emitter electrodes on the back surface, connected to a first and second contact on the back surface respectively. The contacts may be part of bus bars that connect to the interdigitated base and emitter electrodes. In an embodiment, the photovoltaic cells 10 may be cells obtained by cutting a wafer into identical dices. In another embodiment, cells with front and back contacts may be used, with contacts to base and emitter areas on opposite surfaces of the cell respectively. In this embodiment a conductive tab (e.g. a flexible strip of electrically conductive material) may be used for each cell, running from a front contact of the cell to its edge and from there through a space between adjacent cells to a contact to the foil underneath the back surface of the cell or a neighboring cell. However, use of all back contact cells is preferred.

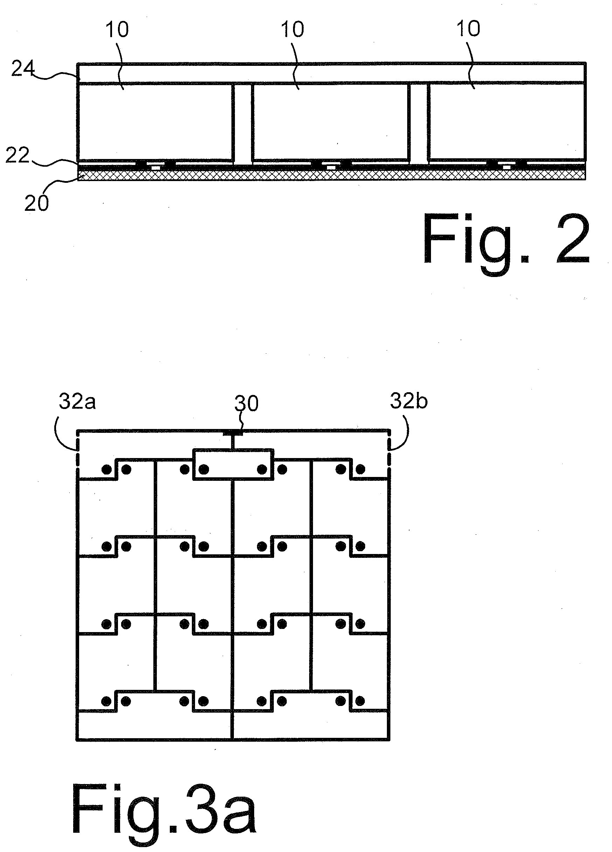

Figure 2 shows a partial cross-section through an assembly of photo-voltaic cells that comprises the matrix (not to scale). The assembly comprises photovoltaic cells 10 of the matrix, an electrically insulating, flexible foil 20 and areas of electrically conductive material 22 (e.g. copper) on foil 20, electrically connected to the contacts of the photovoltaic cells 10. The electrically conductive material 22 on foil 20 are mutually isolated. Photovoltaic cells 10 may be mounted with their front surfaces on a transparent plate 24. Photovoltaic cells 10 may each comprise a layer of electrically insulating encapsulant on their back surface, with openings that define the contacts to the photovoltaic cells 10. Connection material such as a solder or a conductive adhesive may be present in the openings to connect to the areas of electrically conductive material 22.

The connection pattern provided by foil 20 may be defined by distinguishing PxP sub-matrices of photo-voltaic cells 10 (P=4 by way of example), so that the matrix of figure 1 is also a matrix of N/P rows and M/P columns of these sub-matrices.

Figure 3a shows a layout of the areas of the electrically conductive material on a part of the foil within a sub-matrix, which is used in all sub-matrices except for sub-matrices in a column of sub-matrices at the edge of the matrix. The inner lines indicate separations between different areas and the circles indicate holes for contact with the cells. Dashed lines 32a,b of the circumference indicates where the areas may extend to other parts of the foil that contain adjacent sub-matrices. The upper left and right areas run over into areas in columns to the left and right at dashed lines 32a b respectively. In addition figure 3a a bypass diode 30, which may be located on a pair of adjacent areas of electrically conductive material the foil.

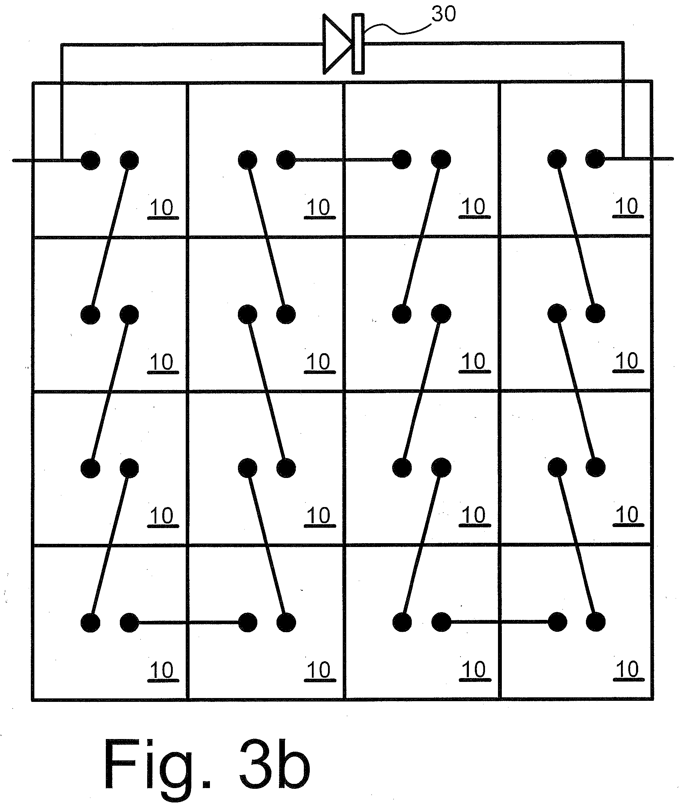

Figure 3b shows cells 10 in the sub-matrix and a schematic connection pattern realized by the areas of the electrically conductive material of figure 3a. The PxP cells of the sub-matrix are connected in series by a plough furrow pattern, which goes down for P cells along a column, then to the next column, then up P cells in that column, then to the next column and so on until all P columns have been visited. In addition figure 3b shows the connection of bypass diode 30, which is connected to bypass the cells in the sub-matrix. As can be seen the bypass diode 30 bypasses P columns, with P greater than two (P=4 in the example of figures 3a,b). The sub-matrix substantially forms a square. In this way the maximum distance between cells that are bypassed by the same bypass diode 30 is minimized. This helps to minimize the effect of common shapes of shadow. In the example square cells are used arranged in the sub-matrix in as many columns as rows. When rectangular cells of width W and height H are used, a PxQ sub-matrix may be used, with a number of columns P unequal to the number of rows Q, but with a smaller difference between P*W and Q*H than between P*H and P*W.

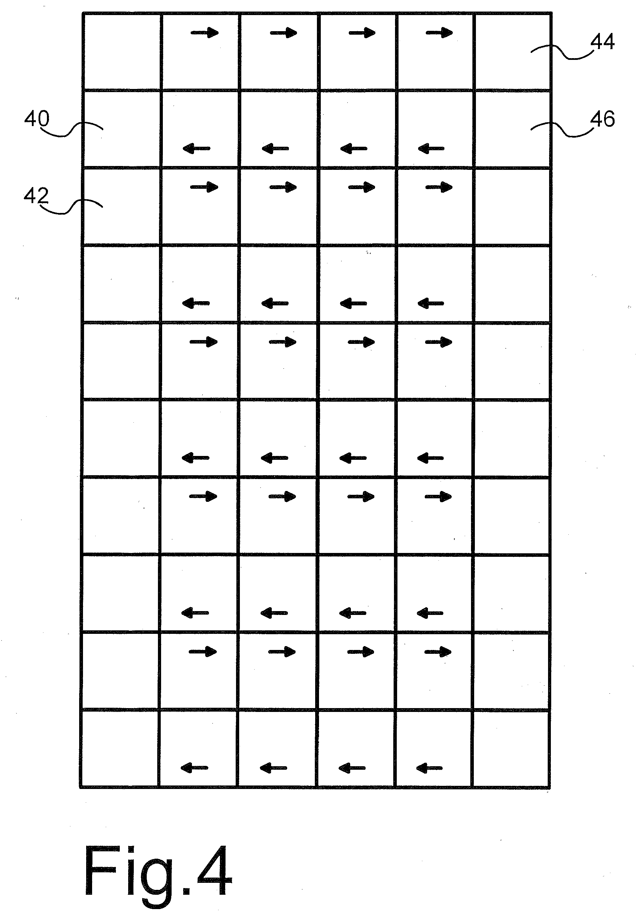

Figure 4 shows the matrix of figure 1 divided into N/P rows and M/P columns of sub-matrices (N/P=6, M/P=10). The odd rows contain sub-matrices with layout as shown in figure 3a (indicated by arrows to the right). The even rows contain sub-matrices with layout as shown in figure 3a but rotated by 180 degrees (indicated by arrows to the left).

The layout in the sub-matrices 40, 42 (only two labeled) at the leftmost column may be very similar to those in the other columns except that the final (lower left) area of electrical conductor material in the leftmost sub-matrices 40 in the even rows run on into the first (upper left) area of electrical conductor material in the leftmost sub-matrix 42 in the next lower odd row. Thus, there is a direct connection between a cell in one sub-matrix with the layout of figure 3a to the next cell in the next lower sub-matrix with the layout of figure 3a.

At the right of the matrix, there is no such direct connection. Instead, each time a detour through P cells along the right edge of the overall matrix is used. Two types of sub-matrices 44, 46 (only two labeled) with PxP cells in even and odd rows of sub-matrices along the right edge can be distinguished, using a different layout compared to the sub-matrices to the left of the rightmost column, although the orientation of the cells in this column is the same as in the remainder of the matrix.

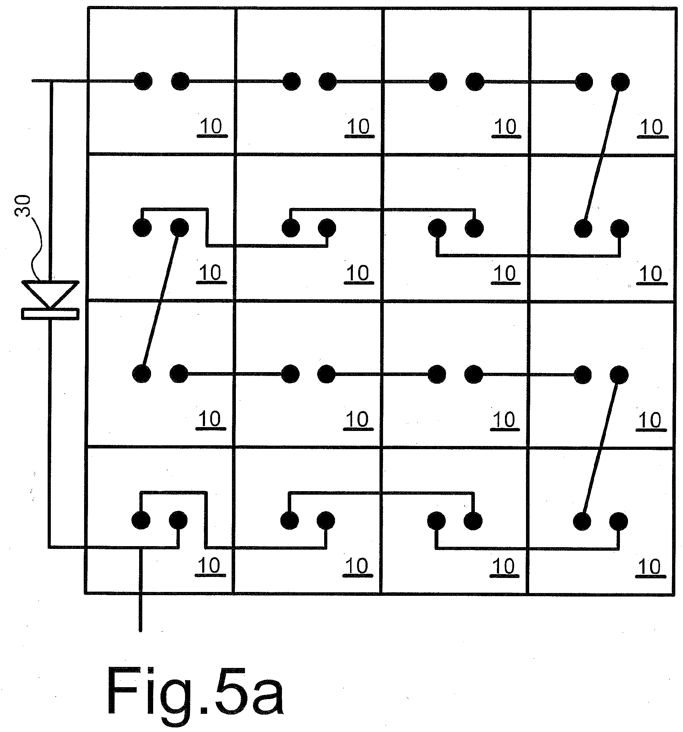

Figure 5a shows PxP cells 10 in a sub-matrix in an odd row of sub-matrices at the rightmost column and a schematic connection pattern of the PxP cells realized by the areas of the electrically conductive material in that sub-matrix. The location of the contacts to the cells in this sub-matrix is the same as that in the other sub-matrices, because the orientation of all cells in the overall matrix is the same. However, the connection pattern differs. Roughly speaking, the PxP cells are connected in series by a plough furrow pattern, which goes right for P cells along a row, then to the next row, then left P cells in that row, then to the next row and so on until all P row have been visited. However, in the even rows, where the series connections are to the left, an "Echternach" series connection is used, which each time starts from a contact one step back (to the right) from the previous contact in the series connection, and steps over the next two contacts to the left to connect to the third contact.

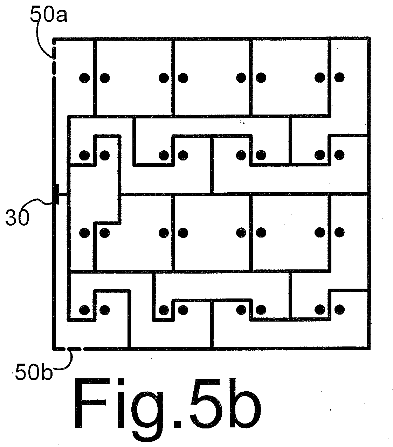

Figure 5b shows a layout of the areas of the electrically conductive material on a part of the foil within a sub-matrix that provides the connection pattern of figure 5a. Again dashed lines 50a,b show where areas run over into areas of an adjacent sub-matrix. The upper left area runs over into the column to the left and the lower left area runs over into the next lower row.

Substantially similar layout and connection patterns are used for the sub-matrices in the even rows of sub-matrices at the rightmost column, except that the upper left area runs over into the next higher row and the lower left area runs over into the column to the left.

The bypass diodes 30 of the sub-matrices in the rightmost columns each bypass the cells in their respective sub-matrix. In the illustrated example, the bypass diodes each bypass cells in a substantially square sub-matrix of PxP cells 10.

As will be appreciated, the connections in the sub-matrices in the rightmost columns ensure that similarly sized connection areas can be used everywhere in the matrix. By using special connections in P columns along the right edge of the matrix, the connection between successive rows of sub-matrices can be realized through a region that is occupied by photovoltaic cells 10. Use of exceptionally long connection areas between successive rows of sub-matrices is not needed.

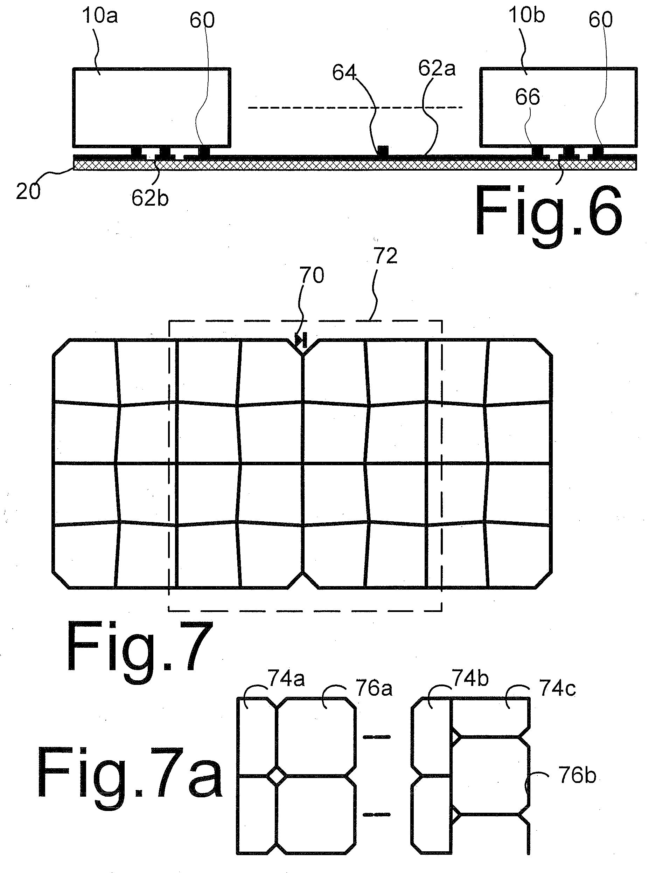

Figure 6 illustrates the principle an embodiment wherein bypass diodes 60 are located between photo-voltaic cells 10a,b and foil 20. By way of illustration, the contacts and the bypass diodes are shown as if they were located in a same cross-section, but in practice this may not be so.

Figure 6 shows the first photo-voltaic cells 10a,b and bypass diodes 60 of the series connections of successive first and second sub-matrices. The other photovoltaic cells in the series connections are not shown. In this embodiment the bypass diode 60 of each sub-matrix has terminals connected to a respective first area 62a of electrically conductive material on the foil 20 and an auxiliary contact of a first photovoltaic cell 10a in the series connection of the sub-matrix. First area 62a connects to a contact 66 to the first photovoltaic cell 10b in the series connection of the next sub-matrix. This first photovoltaic cell 10b in the series connection of the next sub-matrix similarly has an auxiliary contact, a bypass diode 60 being connected between the auxiliary contact and the foil. Conductors on each of the first photovoltaic cells 10a connect the auxiliary contacts to a normal contact of the cell, which serves for collecting current from the first of a first photovoltaic cell 10a.

This normal contact of the first photovoltaic cells 10a in the first sub-matrix is connected to a second area 62b of electrically conductive material on the foil 20, which serves as connection to the normal contact of a further cell (not shown) in the series connection of the first sub-matrix. Apart from connecting the bypass diode 60 to the first photovoltaic cell 10b in the series connection of the second sub-matrix, the first area 62a connects to a normal contact 64 of the last photovoltaic cell (not shown) in the series connection of the first sub-matrix.

Thus the bypass circuit of this sub-matrix runs from second area 62b, through the connection from second area 62b to the contact on the first photovoltaic cell 10a, then via a conductor on the first photovoltaic cell 10a to the bypass diode 60, from there to first area 62a and to the contacts 64, 66 of the second and third photovoltaic cell. Preferably, the contact to bypass diode 60 on first photovoltaic cell 10a is adjacent to the contact from that cell to second area 62b. The figure shows the contacts and the diode 60 in one cross-section to illustrate the connections, but again it is emphasized that in practice the diodes and the contacts need not be in the same cross-section. Connection of bypass diode 60 between an area 62b of electrically conductive material on the foil 20 and a contact to a cell 10a may simplify manufacturing by relaxing location tolerance for bypass diode 60. For example, the bypass diode may be mounted on the first area 62b before the cells and the foil are connected. In embodiment, the bypass diodes of all sub-matrices may be connected in a similar way.

Although examples have been shown wherein all photovoltaic cells in the matrix are rectangular, it should be noted that alternatively non-rectangular cells may be used.

Figure 7 shows an example of a portion of a matrix wherein non-rectangular cells are used. All cells have the same area, which optimizes output. 4 row x 4 column sub-arrangements of cells can be distinguished. Cells at the corners of the sub-arrangements (e.g. from the corners of an array on a wafer) have beveled corners. To achieve a sub-arrangement of rows and columns with equal area cells in this case, non-rectangular cells are used. Measured edge to edge, the cells at the corners are wider and higher on average than the other cells in the same edge row or column in the sub-arrangement, to compensate the area lost to the beveled corners. In turn the other cells in the edge rows are higher on average than non-edge cells and other cells in the edge rows are wider on average than non-edge cells to compensate for area lost to corner cells. The cells may be formed for example by first cutting a wafer with beveled corners along straight lines into four quadrants, and then cutting the quadrants along four lines from the edges that converge at an interior point with coordinates selected to make the four cut parts of the quadrant equal in area, compensating for the lack at the corner due to beveling.

A sub-matrix 72 is formed from cells of a pair of adjacent sub arrangements. In this way, the space left at the beveled corners is available for locating the bypass diode 70 for the sub-matrix. The cells in the sub-matrix may be interconnected as described before.

Fig. 7a shows configuration of sub-arrangements 74a-c. 76a,b of cells in the top two rows of the matrix (the individual cells are not shown). At the left of each row a half sub-arrangement 74a of tow cells wide in the horizontal direction is used, with the beveled corners on the right, i.e after two columns of cells. Next to the right, each row contains a number of full sub-arrangements 76a is used, followed by a half sub-arrangement 74b of two cells wide, with the beveled corners on the left. Along the rows the sub-matrices are formed each time from cells from each time two cells wide, taken from full sub-arrangements, expect at the sides. In the final four columns a similar arrangement as in the rows is used, but rotated by ninety degrees. First a half sub-arrangement 74c, with beveled corners on the lower side, followed downward by a number of full sub-arrangements 76b.In this way space is created for locating the bypass diodes between the cells with beveled corners.

Although examples have been shown wherein all photovoltaic cells in the matrix have the same orientation, it should be appreciated that instead the cells may have different orientations, e.g. with some cells having orientations that are an integer multiple of ninety degrees rotated relative to other cells. This may be used for example to simplify the layout of the electrically conductive material on the foil. For example, the photovoltaic cells in the sub-matrices in the rightmost column may have orientations rotated by ninety degrees with respect to the other cells. In this case, similar layouts may be used in all sub-matrices. However, it is preferred to use a matrix of photovoltaic cells with identical orientations, because this simplifies manufacture.

Although examples have been shown for specific numbers of rows and columns of cells in the overall matrix as well as for sub-matrices with specific numbers of rows and columns P, it should be appreciated that other numbers may be used. P=4 cells in a 4x4 sub-matrix is preferred, as it provides an effective way of reducing the effect of shadows. Of course, the roles columns and rows may be interchanged, as well as the roles of left-right and top-bottom.

Although a connection pattern has been shown that runs through substantially an entire row of sub-matrices and turns at the rightmost matrix, it should be understood that the pattern may turn at any point along the row, sub-matrices of the type shown in figure 5a,b being provided there. For example, the described matrix may be part of a larger matrix wherein the described matrix forms a part with sub-matrices of the type shown in figure 5a,b at the edge of the described matrix. Similarly, a larger number than two of series connected sub-matrices of the type shown in figure 5a,b may be used to connect rows that are not adjacent. In fact, an arbitrary pattern of connection through the matrix of sub-matrices can be realized. As another example, a first and second row of first sub-matrices that are connected by second sub-matrices may lie separated by further first and/or second sub-matrices. In this case the first and second row need not be mirror images of each other. However, it is preferred to use patterns that run through full rows and successively through adjacent rows, as this provides an easy way of limiting voltage differences between adjacent cells.

Although an embodiment with electrical connections by means of a flexible foil with areas of electrically conductive material has been shown, it should be appreciated that instead other connection structures may be used, for example a stiff insulating layer with areas of electrically conductive material.

## Claims

1. An assembly of photovoltaic cells (10), comprising
- photovoltaic cells arranged in a matrix with rows and columns of photovoltaic cells,
- an electrical connection structure providing a series connection of the photovoltaic cells of the matrix, and
- bypass diodes (30), each bypass diode connected in parallel with the photovoltaic cells of a respective part of the series connection, wherein the electrical connection structure comprises
- rows of first sub-matrix connection patterns, each first sub-matrix connection pattern providing one of the respective parts of the series connection, extending over a plurality of rows of photovoltaic cells of the matrix, running back and forth along successive columns through the plurality of rows, **characterised in that** the electrical connection structure further comprises
- second sub-matrix connection patterns, connecting the first sub-matrix connection patterns at ends of a pair of the rows of first sub-matrix connection patterns, each second sub-matrix connection pattern providing a further one of the respective parts of the series connection, extending over a plurality of columns of photovoltaic cells of the matrix, running back and forth along successive rows through the plurality of columns.

2. An assembly according to claim 1, wherein said pair lies between further ones of the rows of the first sub-matrix connection patterns located adjacent the rows in said pair, wherein the first sub-matrix connection patterns at further ends of the rows in the pair, opposite said ends where the second sub-matrix connection patterns connect the rows of the pair, are connected directly to adjacent first sub-matrix connection patterns in the further ones of the rows.

3. An assembly according to any of the preceding claims, wherein the rows in the pair are adjacent to each other, the electrical connection structure comprising
- a plurality of such pairs of adjacent rows of first sub-matrix connection patterns,
- a column of the second sub-matrix connection patterns, connecting the first sub-matrix connection patterns within the pairs and
- direct connections between the first sub-matrix connection patterns of adjacent rows from successive ones of the pairs at further ends of the rows opposite said ends where the second sub-matrix connection patterns connect the first sub-matrix connection patterns.

4. An assembly according to any of the preceding claims, wherein, in each row of the pair, the first sub-matrix connection pattern at said end connects the second sub-matrix connection pattern in series to a photovoltaic cell at a first corner of a sub-matrix of photovoltaic cells that are connected by said part of the series connection that is provided by the first sub-matrix connection pattern, the first corners in each row of the pair lying away from the other row of the pair, with intermediate photovoltaic cells between the photovoltaic cell at the first corners.

5. An assembly according to claim 1, wherein the first sub-matrix connection patterns at the ends of the pair of the rows each run back and forth through a first number P of rows, and the second sub-matrix connection patterns each run said first number P times back and forth through the plurality of columns.

6. An assembly according to claim 5, wherein the first sub-matrix connection patterns at the ends of the pair of the rows each run a second number Q times back and forth through said first number P of rows, and the second sub-matrix connection patterns each run said first number P times back and forth through said second number Q of columns.

7. An assembly according to claim 6, wherein the first number P and the second number Q are equal.

8. An assembly according to any of the preceding claims, wherein the bypass diodes are located at edges of the first and second sub-matrix connection patterns.

9. An assembly according to any of the preceding claims, wherein all photovoltaic cells are arranged having identical orientations in the matrix, the first sub-matrix connection pattern having identical layouts, the second sub-matrix connection pattern having layouts that differ from that of the first sub-matrix connection pattern.

10. An assembly according to any of the preceding claims, wherein each of the first and second sub-matrix connection patterns comprises a first and second one of the photovoltaic cells at the ends of the respective part of the series connection that is provided by the sub-matrix connection pattern, the first and second one of the photovoltaic cells being located along a straight edge of the sub-matrix connection pattern, the electrical connection structure in the sub-matrix connection pattern comprising a pair of areas of electrically conducting material extending along said edge, electrically connected to contacts of the first and second one of the photovoltaic cells respectively, the bypass diode that is connected in parallel with the photovoltaic cells of the respective part of the series connection being located at said edge, electrically connected between the pair of areas.

11. An assembly according to any of claims 1-9, wherein each of the first and second sub-matrix connection patterns comprises a first and second one of the photovoltaic cells at the ends of the respective part of the series connection that is provided by the sub-matrix connection pattern, the electrical connection structure in the sub-matrix connection pattern comprising a first and second areas of electrically conducting material, electrically connected to contacts of the first and second one of the photovoltaic cells respectively, the bypass diode that is connected in parallel with the photovoltaic cells of the respective part of the series connection being located sandwiched between a further contact of the first one of the photovoltaic cells and the second area of electrically conducting material.

12. An assembly according to any of claims 1-11, wherein at least one first sub-matrix comprises a pair of cells from the matrix that have beveled corners adjacent each other, leaving a space between the beveled corners of the cells in that pair, the bypass diode of said at least one first sub-matrix being located in said space.

13. An assembly according to claim 12, wherein the cells of said pair are located at the corners of respective quadrants of said at least one first sub-matrix, each of said quadrants comprising a respective sub-set of the cells of the matrix, the directions of edges of the cells in the quadrant deviating from the row and column direction to equalize the areas of the cells in the quadrant, compensating for area reduction due to the beveled corner.

14. An assembly according to any of the preceding claims, wherein the photovoltaic cells are back contact cells, each photovoltaic cell having back surface that contains contacts to base and emitter areas of the cell respectively.

15. A method of manufacturing an assembly of photovoltaic cells, the method comprising
- providing an electrical connection structure that provides for a series connection of the photovoltaic cells (10),
- providing bypass diodes (30) on said electrical connection structure, each bypass diode for connection in parallel with the photovoltaic cells of a respective part of the series connection;
- arranging the photovoltaic cells in a matrix with rows and columns of photovoltaic cells;
- establishing electrical contact between contacts of the photovoltaic cells and the electrical connection structure, wherein the electrical connection structure comprises
- rows of first sub-matrix connection patterns, each first sub-matrix connection pattern providing one of the respective parts of the series connection, extending over a plurality of rows of photovoltaic cells of the matrix, running back and forth along successive columns through the plurality of rows, **characterised in that** the electrical connection structure further comprises
- second sub-matrix connection patterns, connecting the first sub-matrix connection patterns at ends of a pair of the rows of first sub-matrix connection patterns, each second sub-matrix connection pattern providing a further one of the respective parts of the series connection, extending over a plurality of columns of photovoltaic cells of the matrix, running back and forth along successive rows through the plurality of columns.

16. A method according to claim 15, comprising using photovoltaic cells cut from wafers, and arranging the cells cut from the wafers in said step of arranging the photovoltaic cells in the matrix with rows and columns of photovoltaic cells.

## Patentansprüche

1. Anordnung von Photovoltaikzellen (10), umfassend
- Photovoltaikzellen, angeordnet in einer Matrix mit Reihen und Spalten von Photovoltaikzellen,
- eine elektrische Verbindungsstruktur, die eine Serienverbindung der Photovoltaikzellen der Matrix bereitstellt, und
- Bypass-Dioden (30), jede Bypass-Diode parallel verbunden mit den Photovoltaikzellen eines entsprechenden Teils der Serienverbindung, wobei die elektrische Verbindungsstruktur Folgendes umfasst:
- Reihen von ersten Submatrix-Verbindungsmustern, von denen jedes erste Submatrix-Verbindungsmuster einen der entsprechenden Teile der Serienverbindung bereitstellt, verlaufend über eine Vielzahl von Reihen von Photovoltaikzellen der Matrix, die zurück und vor entlang aufeinanderfolgender Spalten durch die Vielzahl von Reihen laufen, **dadurch gekennzeichnet, dass** die elektrische Verbindungsstruktur ferner umfasst:
- zweite Submatrix-Verbindungsmuster, welche die ersten Submatrix-Verbindungsmuster an Enden eines Paares der Reihen der ersten Submatrix-Verbindungsmuster verbinden, wobei jedes zweite Submatrix-Verbindungsmuster einen weiteren der entsprechenden Teile der Serienverbindung bereitstellt, verlaufend über eine Vielzahl von Spalten der Photovoltaikzellen der Matrix, laufend zurück und vor entlang aufeinanderfolgender Reihen durch die Vielzahl von Spalten.

2. Anordnung nach Anspruch 1, wobei das Paar zwischen weiteren der Reihen der ersten Submatrix-Verbindungsmuster liegt, angeordnet neben der Reihen in dem Paar, wobei die ersten Submatrix-Verbindungsmuster an weiteren Enden der Reihen in dem Paar, gegenüber der Enden, wo die zweiten Submatrix-Verbindungsmuster die Reihen des Paares verbinden, direkt mit benachbarten ersten Submatrix-Verbindungsmustern in den weiteren der Reihen verbunden sind.

3. Anordnung nach einem der vorhergehenden Ansprüche, wobei die Reihen in dem Paar nebeneinander sind, die elektrische Verbindungsstruktur umfassend
- eine Vielzahl solcher Paare benachbarter Reihen der ersten Submatrix-Verbindungsmuster,
- eine Spalte der zweiten Submatrix-Verbindngsmuster, welche die ersten Subatrix-Verbindungsmuster innerhalb der Paare verbindet, und
- direkte Verbindungen zwischen den ersten Submatrix-Verbindungsmustern benachbarter Reihen von aufeinanderfolgenden der Paare an weiteren Enden der Reihen gegenüber der Enden, wo die zweiten Submatrix-Verbindungsmuster die ersten Submatrix-Verbindungsmuster verbinden.

4. Anordnung nach einem der vorhergehenden Ansprüche, wobei in jeder Reihe des Paares das erste Submatrix-Verbindungsmuster an dem Ende das zweite Submatrix-Verbindungsmuster in Serie mit einer Photovoltaikzelle an einer ersten Ecke der Submatrix von Photovoltaikzellen, die durch den Teil der Serienverbindung, die von dem ersten Submatrix-Verbindungsmuster bereitgestellt wird, verbinden, welche ersten Ecken in jeder Reihe des Paares weg von der anderen Reihe des Paares liegen, mit Photovoltaikzellen zwischen der Photovoltaikzelle an den ersten Ecken.

5. Anordnung nach Anspruch 1, wobei die ersten Submatrix-Verbindungsmuster an den Enden des Paares der Reihen jeweils zurück und vor durch eine erste Anzahl P von Reihen laufen und die zweiten Submatris-Verbindungsmuster jeweils die erste Anzahl P Male zurück und vor durch die Vielzahl von Spalten laufen.

6. Anordnung nach Anspruch 5, wobei die ersten Submatrix-Verbindungsmuster an den Enden des Paares der Reihen jeweils eine zweite Anzahl von Q Malen zurück und vor durch die erste Anzahl P von Reihen laufen und die zweiten Submatrix-Verbindungsmuster jeweils die erste Anzahl P von Malen zurück und vor durch die zweite Anzahl Q von Spalten laufen.

7. Anordnung nach Anspruch 6, wobei die erste Anzahl P und die zweite Anzahl Q gleich sind.

8. Anordnung nach einem der vorhergehenden Ansprüche, wobei die Bypass-Dioden sich an Rändern der ersten und zweiten Submatrix-Verbindungsmuster befinden.

9. Anordnung nach einem der vorhergehenden Ansprüche, wobei alle Photovoltaikzellen in identischen Ausrichtungen in der Matrix angeordnet sind, wobei das erste Submatrix-Verbindungsmuster identische Layouts aufweist, das zweite Submatrix-Verbindungsmuster Layouts aufweist, die sich von dem des ersten Submatrix-Verbindungsmusters unterscheiden.

10. Anordnung nach einem der vorhergehenden Ansprüche, wobei jedes der ersten und zweiten Submatrix-Verbindungsmuster eine erste und zweite der Photovoltaikzellen an den Enden des entsprechenden Teils der Serienverbindung, die von dem Submatrix-Verbindungsmuster bereitgestellt wird, umfasst, welche erste und zweite der Zellen sich entlang einer geraden Kante des Submatrix-Verbindungsmusters befindet, die elektrische Verbindungsstruktur in dem Submatrix-Verbindungsmuster umfassend ein Paar von Bereichen von elektrisch leitendem Material, verlaufend entlang der Kante, elektrisch verbunden mit Kontakten von jeweils der ersten und zweiten der Photovoltaikzellen, wobei die Bypass-Diode, die parallel mit den Photovoltaikzelle des entsprechenden Teils der Serienverbindung sich an der Kante befindet, elektrisch verbunden zwischen dem Paar von Bereichen.

11. Anordnung nach einem der Ansprüche 1-9, wobei jedes der ersten und zweiten Submatrix-Verbindungsmuster eine erste und zweite der Photovoltaikzellen an den Enden des entsprechenden Teils der Serienverbindung, die von dem Submatrix-Verbindungsmuster bereitgestellt wird, umfasst, die elektrische Verbindungsstruktur in dem Submatrix-Verbindungsmuster umfassend einen ersten und zweiten Bereich von elektrisch leitendem Material, elektrisch verbunden mit Kontakten von jeweils der ersten und zweiten der Photovoltaikzellen, wobei die Bypass-Diode, die parallel mit den Photovoltaikzellen des entsprechenden Teils der Serienverbindung verbunden ist, sich zwischen einem weiteren Kontakt der ersten der Photovoltaikzellen und dem zweiten Bereich von elektrisch leitendem Material befindet.

12. Anordnung nach einem der Ansprüche 1-11, wobei mindestens eine erste Submatrix mit abgeschrägten Ecken nebeneinander umfasst, sodass ein Raum zwischen den abgeschrägten Ecken der Zellen in diesem Paar frei bleibt, in welchem Raum sich die Bypass-Diode der mindestens einen ersten Submatrix befindet.

13. Anordnung nach Anspruch 12, wobei die Zellen des Paares sich an den Ecken von entsprechenden Quadranten der mindestens einen ersten Submatrix befinden, jeder der Quadranten umfassend einen entsprechenden Teilsatz der Zellen der Matrix, wobei die Richtungen von Kanten der Zellen in dem Quadranten von der Reihen- und Spaltenrichtung abweichen, um die Bereiche der Zelle in dem Quadranten auszugleichen, sodass eine Bereichsreduzierung aufgrund der abgeschrägten Ecke kompensiert wird.

14. Anordnung nach einem der vorhergehenden Ansprüche, wobei die Photovoltaikzellen Rückkontaktzellen sind, jede der Zellen versehen mit einer rückseitigen Oberfläche aufweist, die Kontakte zu jeweils Basis- und Emitterbereichen der Zelle enthält.

15. Verfahren zur Herstellung einer Anordnung von Photovoltaikzellen, das Verfahren umfassend
- das Bereitstellen einer elektrischen Verbindungsstruktur, die eine Serienverbindung der Photovoltaikzellen (10) bereitstellt,
- das Bereitstellen von Bypass-Dioden (30) auf der elektrischen Verbindungsstruktur, jede der Bypass-Dioden zur parallelen Verbindung mit den Photovoltaikzellen eines entsprechenden Teils der Serienverbindung;
- das Anordnen der Photovoltaikzellen in einer Matrix mit Reihen und Spalten von Photovoltaikzellen;
- das Herstellen eines elektrischen Kontakts zwischen Kontakten der Photovoltaikzellen und der elektrischen Verbindungsstruktur, wobei die elektrische Verbindungsstruktur Folgendes umfasst:
- Reihen von ersten Submatrix-Verbindungsmustern, von denen jedes erste Submatrix-Verbindungsmuster einen der entsprechenden Teile der Serienverbindung bereitstellt, verlaufend über eine Vielzahl von Reihen von Photovoltaikzellen der Matrix, laufend zurück und vor entlang aufeinanderfolgender Spalten durch die Vielzahl von Reihen, **dadurch gekennzeichnet, dass** die elektrische Verbindungsstruktur ferner Folgendes umfasst:
- zweite Submatrix-Verbindungsmuster, welche die ersten Submatrix-Verbindungsmuster an Enden eines Paares der Reihen der ersten Submatrix-Verbindungsmuster verbinden, wobei jedes zweite Submatrix-Verbindungsmuster einen weiteren der entsprechenden Teile der Serienverbindung bereitstellt, verlaufend über eine Vielzahl von Zellen der Matrix, laufend zurück und vor entlang aufeinanderfolgender Reihen durch die Vielzahl von Spalten.

16. Verfahren nach Anspruch 15, umfassend die Verwendung von Photovoltaikzellen, geschnitten aus Wafern, und das Anordnen der aus den Wafern geschnittenen Zellen in dem Schritt, in dem die Photovoltaikzellen in der Matrix mit Reihen und Spalten von Photovoltaikzellen angeordnet werden.

## Revendications

1. Ensemble de cellules photovoltaïques (10) comprenant :
- des cellules photovoltaïques disposées en une matrice comportant des rangées et des colonnes de cellules photovoltaïques,
- une structure de connexion électrique procurant une connexion en série des cellules photovoltaïques de la matrice, et
- des diodes en parallèle (30), chaque diode en parallèle étant connectée en parallèle aux cellules photovoltaïques d'une partie respective de la connexion en série, dans lequel la structure de connexion électrique comprend :
- des rangées de premiers motifs de connexion de sous-matrice, chaque premier motif de connexion de sous-matrice procurant l'une des parties respectives de la connexion en série, s'étendant sur une pluralité de rangées de cellules photovoltaïques de la matrice, en va-et-vient le long de colonnes successives à travers la pluralité de rangées, **caractérisé en ce que** la structure de connexion électrique comprend en outre :
- des seconds motifs de connexion de sous-matrice, connectant les premiers motifs de connexion de sous-matrice à des extrémités d'une paire des rangées de premiers motifs de connexion de sous-matrice, chaque second motif de connexion de sous-matrice procurant une autre des parties respectives de la connexion en série, s'étendant sur une pluralité de colonnes de cellules photovoltaïques de la matrice, en va-et-vient le long de rangées successives à travers la pluralité de colonnes.

2. Ensemble selon la revendication 1, dans lequel ladite paire se trouve entre d'autres des rangées des premiers motifs de connexion de sous-matrice situées adjacentes aux rangées de ladite paire, dans lequel les premiers motifs de connexion de sous-matrice à d'autres extrémités des rangées de la paire, opposées auxdites extrémités où les seconds motifs de connexion de sous-matrice connectent les rangées de la paire, sont connectés directement à des premiers motifs adjacents de connexion de sous-matrice sur les autres des rangées.

3. Ensemble selon l'une quelconque des revendications précédentes, dans lequel les rangées de la paire sont adjacentes l'une à l'autre, la structure de connexion électrique comprenant :
- une pluralité de telles paires de rangées adjacentes de premiers motifs de connexion de sous-matrice,
- une colonne des seconds motifs de connexion de sous-matrice, connectant les premiers motifs de connexion de sous-matrice au sein des paires, et
- des connexions directes entre les premiers motifs de connexion de sous-matrice de rangées adjacentes parmi des rangées successives des paires à d'autres extrémités des rangées opposées auxdites extrémités où les seconds motifs de connexion de sous-matrice connectent les premiers motifs de connexion de sous-matrice.

4. Ensemble selon l'une quelconque des revendications précédentes, dans lequel dans chaque rangée de la paire, le premier motif de connexion de sous-matrice à ladite extrémité connecte le second motif de connexion de sous-matrice en série à une cellule photovoltaïque à un premier coin de sous-matrice de cellules photovoltaïques qui sont connectées par ladite partie de la connexion en série qui est procurée par le premier motif de connexion de sous-matrice, les premiers coins de chaque rangée de la paire se trouvant à distance de l'autre rangée de la paire, des cellules photovoltaïques intermédiaires se trouvant entre la cellule photovoltaïque aux premiers coins.

5. Ensemble selon la revendication 1, dans lequel les premiers motifs de connexion de sous-matrice aux extrémités de la paire des rangées s'étendent en va-et-vient chacun à travers un premier nombre P de rangées, et les seconds motifs de connexion de sous-matrice s'étendent en va-et-vient chacun ledit premier nombre P de fois à travers la pluralité de colonnes.

6. Ensemble selon la revendication 5, dans lequel les premiers motifs de connexion de sous-matrice aux extrémités de la paire des rangées s'étendent en va-et-vient chacun un second nombre Q de fois à travers ledit premier nombre P de rangées, et les seconds motifs de connexion de sous-matrice s'étendent en va-et-vient chacun ledit premier nombre P de fois à travers ledit second nombre Q de colonnes.

7. Ensemble selon la revendication 6, dans lequel le premier nombre P et le second nombre Q sont égaux.

8. Ensemble selon l'une quelconque des revendications précédentes, dans lequel les diodes en parallèle se situent à des bords des premiers et seconds motifs de connexion de sous-matrice.

9. Ensemble selon l'une quelconque des revendications précédentes, dans lequel toutes les cellules photovoltaïques sont disposées de manière à avoir des orientations identiques dans la matrice, le premier motif de connexion de sous-matrice ayant des topologies identiques, le second motif de connexion de sous-matrice ayant des topologies qui diffèrent de celle du premier motif de connexion de sous-matrice.

10. Ensemble selon l'une quelconque des revendications précédentes, dans lequel chacun des premiers et seconds motifs de connexion de sous-matrice comprend une première et une seconde des cellules photovoltaïques aux extrémités de la partie respective de la connexion en série qui est procurée par le motif de connexion de sous-matrice, la première et la seconde des cellules photovoltaïques étant situées le long d'un bord droit du motif de connexion de sous-matrice, la structure de connexion électrique dans le motif de connexion de sous-matrice comprenant une paire de zones de matériau conducteur de l'électricité s'étendant le long dudit bord, électriquement reliées à des contacts de la première et de la seconde des cellules photovoltaïques respectivement, la diode en parallèle qui est connectée en parallèle aux cellules photovoltaïques de la partie respective de la connexion en série étant située audit bord, électriquement reliée entre la paire de zones.

11. Ensemble selon l'une quelconque des revendications 1 à 9, dans lequel chacun des premiers et seconds motifs de connexion de sous-matrice comprend une première et une seconde des cellules photovoltaïques aux extrémités de la partie respective de la connexion en série qui est procurée par le motif de connexion de sous-matrice, la structure de connexion électrique dans le motif de connexion de sous-matrice comprenant des première et seconde zones de matériau conducteur de l'électricité, électriquement reliées à des contacts de la première et de la seconde des cellules photovoltaïques respectivement, la diode en parallèle qui est connectée en parallèle aux cellules photovoltaïques de la partie respective de la connexion en série se trouvant prise en sandwich entre un autre contact de la première des cellules photovoltaïques et la seconde zone de matériau conducteur de l'électricité.

12. Ensemble selon l'une quelconque des revendications 1 à 11, dans lequel au moins une première sous-matrice comprend une paire de cellules parmi la matrice, qui ont des coins biseautés adjacents l'un à l'autre, laissant un espace entre les coins biseautés des cellules de cette paire, la diode en parallèle de ladite au moins une première sous-matrice se trouvant dans ledit espace.

13. Ensemble selon la revendication 12, dans lequel les cellules de ladite paire se situent aux coins de secteurs respectifs de ladite au moins une première sous-matrice, chacun desdits secteurs comprenant un sous-ensemble respectif des cellules de la matrice, les directions de bords des cellules du secteur déviant de la direction de rangées et de colonnes pour égaliser les aires des cellules du secteur, en compensant une réduction d'aire due au coin biseauté.

14. Ensemble selon l'une quelconque des revendications précédentes, dans lequel les cellules photovoltaïques sont des cellules à contacts arrière, chaque cellule photovoltaïque présentant une surface arrière qui contient des contacts respectivement avec les zones de base et d'émetteur de la cellule.

15. Procédé de fabrication d'un ensemble de cellules photovoltaïques, le procédé comprenant les étapes suivantes :
- utiliser une structure de connexion électrique qui procure une connexion en série des cellules photovoltaïques (10),
- utiliser des diodes en parallèle (30) sur ladite structure de connexion électrique, chaque diode en parallèle étant destinée à une connexion en parallèle aux cellules photovoltaïques d'une partie respective de la connexion en série ;
- disposer les cellules photovoltaïques en une matrice comportant des rangées et des colonnes de cellules photovoltaïques ;
- établir un contact électrique entre des contacts des cellules photovoltaïques et la structure de connexion électrique, dans lequel la structure de connexion électrique comprend :
- des rangées de premiers motifs de connexion de sous-matrice, chaque premier motif de connexion de sous-matrice procurant l'une des parties respectives de la connexion en série, s'étendant sur une pluralité de rangées de cellules photovoltaïques de la matrice, en va-et-vient le long de colonnes successives à travers la pluralité de rangées, **caractérisé en ce que** la structure de connexion électrique comprend en outre :
- des seconds motifs de connexion de sous-matrice, connectant les premiers motifs de connexion de sous-matrice à des extrémités d'une paire des rangées de premiers motifs de connexion de sous-matrice, chaque second motif de connexion de sous-matrice procurant une autre des parties respectives de la connexion en série, s'étendant sur une pluralité de colonnes de cellules photovoltaïques de la matrice, en va-et-vient le long de rangées successives à travers la pluralité de colonnes.

16. Procédé selon la revendication 15, comprenant l'utilisation de cellules photovoltaïques découpées dans des tranches, et la disposition des cellules découpées dans les tranches à ladite étape de disposition des cellules photovoltaïques dans la matrice comportant des rangées et des colonnes de cellules photovoltaïques.
